# EUROPÄISCHE PATENTSCHRIFT

(11) **EP 1 848 260 B1**
(45) Veröffentlichungstag und Bekanntmachung des Hinweises auf die Patenterteilung: **03.06.2009**
(21) Anmeldenummer: 07006638.6
(22) Anmeldetag: 30.03.2007
(51) Int. Cl.: H05K 7/20, H05K 1/14

(54) **Wechselrichter**
Inverter
Onduleur

(30) Priorität: 22.04.2006 DE 102006018854
(43) Veröffentlichungstag der Anmeldung: 24.10.2007
(73) Patentinhaber: SMA Solar Technology AG, 34266 Niestetal (DE)
(72) Erfinder: Falk, Andreas, 34131 Kassel (DE); Yasat, Nafiz, 33098 Paderborn (DE)
(74) Vertreter: Walther, Walther & Hinz GbR

(56) Entgegenhaltungen:
- DE-A1- 10 048 379
- JP-A- 10 227 489
- JP-A- 11 113 267
- JP-A- 2005 123 459
- US-A- 5 946 192
- US-B1- 6 704 202

## Beschreibung

Die Erfindung betrifft einen Wechselrichter.

Aus der DE 100 48 379 A1 ist eine elektronische Steuereinheit zur Steuerung des Motors eines Kraftfahrzeugs bekannt. Die Steuereinheit besteht aus einem Gehäuse mit einem Gehäuseboden, der als Abstrahlungsplatte oder Wärmesenke ausgebildet ist. Auf diesem Gehäuseboden sind Leistungstransistoren angeordnet. Darüber befindet sich eine das Gehäuse teilende Leiterplatte, die eine CPU oder einen Mikrocomputer aufweist.

In der JP 2005123459 A ist ein Kühlkörper beschrieben, der im Inneren ein Rohr aufweist, das aus dem Kühlkörper hervorragt und an seinen überstehenden Enden Kühlrippen zeigt. Auf dem Kühlkörper befinden sich wärmeabgebende Halbleiterbauelemente. In dem Rohr, das evakuiert ist, befindet sich eine geringe Menge an Flüssigkeit, die in dem Rohr unter Wärmeeinwirkung verdampft. Da das Rohr schrägstehend angeordnet ist, steigt der Dampf in Richtung des Rohrabschnitts mit den Kühlrippen, kondensiert dort und gelangt dann wieder an den unteren Endpunkt des Rohres, wo der Kühlkreislauf wieder von vorn beginnt.

Wechselrichter sind aus vielen Gebieten der Elektrotechnik bekannt, insbesondere aus der Fotovoltaik, aber auch aus anderen alternativen Stromerzeugungseinrichtungen, wie z. B. Windkraftanlagen und auch Biogasanlagen. Darüber hinaus werden Batteriewechselrichter benötigt, um mit einer Batterie als Energiequelle ein Wechselspannungsnetz für Verbraucher bereitzustellen, die nicht am öffentlichen Stromversorgungsnetz angeschlossen sind. Mit Hilfe derartiger Wechselrichter wird ein Gleichstrom in einen Wechselstrom umgewandelt. Hierzu sind erforderlich Schaltelemente, insbesondere Halbleiterbauelemente, wie AC/DC-Wandler sowie in Abhängigkeit von der Schaltungstopologie auch magnetische Bauelemente, wie Transformatoren oder Drosseln.

Um das Gewicht derartiger Stromrichter zu reduzieren, werden entsprechend dem Stand der Technik zunehmend HF-Topologien mit HF-Transformatoren zur galvanischen Trennung eingesetzt. Dabei sind mehrere leistungselektronische Wandlungsstufen hintereinander geschaltet. Dadurch entsteht die Notwendigkeit, mehrere Leistungshalbleiter an verschiedenen Stellen der Schaltung zu entwärmen. Entsprechend dem Stand der Technik sind die Halbleiter z. B. als Module auf der Unterseite der zugehörigen Leiterplatten angeordnet.

Aus der JP 11113267 A ist ein Wechselrichter bekannt, der allerdings über kein Gehäuse verfügt. Der Wechselrichter zeigt einen stufenförmigen Kühlkörper, wobei jede Stufe eine Wechselrichterbrückenschaltung aufweist. Die Brückenschaltungen sind mit einer darüber befindlichen Leiterplatte verbunden. Eine platzsparende Bauweise zeigt diese Literaturstelle nicht.

Wechselrichter werden häufig im Außenbereich eingesetzt. Das heißt, die Gehäuse müssen wetterfest und dicht sein. Ein solches wetterfestes Gehäuse eines Wechselrichters aus dem Stand der Technik zeichnet sich z. B. dadurch aus, dass das Gehäuse selbst hermetisch gegen Umwelteinflüsse abgeschirmt ist, allerdings auf seiner Gehäuseaußenseite Kühlrippen aufweist. Um nun eine Überhitzung der im Gehäuse angeordneten Bauteile, wie Halbleiterbauelemente und auch magnetische Bauelemente, wie Transformatoren und Drosseln, zu verhindern, befindet sich im Gehäuse ein Lüfter, der die Luft im Gehäuse kontinuierlich umwälzt. Die während des Betriebes des Wechselrichters entstehende Wärme wird über das Gehäuse und die auf dem Gehäuse angeordneten Kühlrippen an die Umgebung abgegeben.

Ein solchermaßen aufgebauter Wechselrichter hat verschiedene Nachteile; so ist insbesondere die Kühlung nur bedingt ausreichend, was insbesondere bei hohen Außentemperaturen zu einem frühzeitigen Abschalten des Stromrichters aufgrund von Überhitzung führt. Weiterhin stellt ein Lüfter ein Verschleißteil dar. Aufgrund der Anordnung der Kühlrippen auf dem gesamten Umfang des Gehäuses wird auch die Gehäuseseite, die dem Bediener zugewandt ist, sehr heiß, so dass der Bediener Schaden nehmen kann. Die Wärmeentwicklung der im Stromrichtergehäuse angeordneten Bauteile ist insbesondere dann von Relevanz, wenn diese im Niederfrequenzbereich arbeiten. Dies deshalb, weil dann ein großer Trafo erforderlich ist, der eine entsprechende Wärmemenge abgibt, die schlussendlich durch das Gehäuse nach außen abgegeben werden muss.

Darüber hinaus sind derartige Niederfrequenz-Wechselrichter relativ voluminös, was einen erhöhten Platzbedarf für die Anbringung an einem Gebäudeteil erfordert.

Andere Stromrichter mit einer HF-Topologie, entsprechend dem Stand der Technik, weisen eine oder mehrere Leiterplatten auf, auf denen nebeneinander mehrere Halbleiter durch einen Kühlkörper entwärmt werden. Bei einem solchen Aufbau ergibt sich als Nachteil eine große Grundfläche.

Der Erfindung liegt daher die Aufgabe zugrunde, ein Gehäuse eines Wechselrichters bereitzustellen, das wetterfest und insbesondere dicht ist, eine gering benötigte Grundfläche aufweist und dennoch eine ausreichende Kühlung der Bauteile des Wechselrichters auch bei hohen Außentemperaturen ermöglicht. Eine geringe Grundfläche ist von Vorteil, damit in einem elektrischen Betriebsraum nur eine kleine Wandfläche zur Aufhängung benötigt wird. Hinzu kommt, dass berührbare Gehäuseteile nicht heiß werden sollen. Das heißt, es soll ein Gehäuse eines Wechselrichters bereitgestellt werden, das eigentlich konträre Konstruktionsprinzipien verbinden soll, nämlich eine kompakte Bauweise bei gleichzeitig optimaler Kühlung.

Die Aufgabe wird nach einem ersten Ausführungsform eines Wechselrichters erfindungsgemäß dadurch gelöst, dass der Boden des Gehäuses stufenförmig gebildet ist, wobei die Kühlkörper an dem stufenförmigen Boden außen angeordnet sind, wobei mindestens zwei Leiterplatten vorgesehen sind, die einander überlappend durch Halbleiterbauelemente mit dem jeweiligen Kühlkörper in Verbindung stehen. Durch die stufenförmige Ausbildung des Gehäusebodens besteht die Möglichkeit, die Leiterplatten ebenfalls stufenförmig versetzt übereinander und einander überlappend anzuordnen, wodurch eine Bauweise mit minimaler Grundfläche verwirklicht wird. Durch die somit überlappende Anordnung der Leiterplatten ergibt sich eine platzsparende Bauweise. Die Anordnung des Kühlkörpers außerhalb des Gehäuses, und hier insbesondere zwischen der Wand, z. B. eines elektrischen Betriebsraumes und dem Gehäuse, sorgt nicht nur für eine ausreichende Kühlung, sondern darüber hinaus dafür, dass der Kühlkörper von außen nicht ohne Weiteres zugänglich ist.

Dadurch, dass jede Leiterplatte mit einem Kühlkörper in Verbindung steht und die Größe der Kühlkörper entsprechend dem stufenförmigen Verlauf des Gehäusebodens gewählt ist, wird der Einsatz unterschiedlich hoher und damit unterschiedlich großer Kühlkörper ermöglicht, und zwar insofern, als in dem stufenförmigen Einsprung des Gehäusebodens ein großer Kühlkörper eingesetzt werden kann, wohingegen im anderen Bereich des Gehäusebodens der Kühlkörper flacher sein kann. Dies trägt insbesondere auch der Tatsache Rechnung, dass unterschiedlich große Leiterplatten zum Einsatz kommen, wobei die größere Leiterplatte über der kleineren Leiterplatte im Gehäuse des Wechselrichters angeordnet ist, so dass der größeren Leiterplatte auch der entsprechend größere Kühlkörper zugeordnet ist. Das heißt, dass die Höhe der Kühlkörper an dem stufenförmigen Boden derart gewählt ist, dass die Rippenseiten der Kühlkörper im eingebauten Zustand eine Ebene bilden, trotz unterschiedlicher Höhe der Kühlkörper.

Nach einer zweiten Variante ist zur Lösung der Aufgabe erfindungsgemäß vorgesehen, dass der Wechselrichter mit mindestens einem außerhalb des Gehäuses angeordneten Kühlkörper und mindestens zwei Leiterplatten versehen ist, die mit dem mindestens einen Kühlkörper durch Halbleiterbauelemente in Verbindung stehen, wobei die eine Leiterplatte die andere Leiterplatte im Gehäuse schrägstehend überlappt.

Im Einzelnen ist die schrägstehende Leiterplatte durch eine Rampe mit dem mindestens einen Kühlkörper verbunden. Die Rampe stellt sich als wärmeleitender Klotz mit schräger Aufnahmefläche dar, wobei vorzugsweise zwischen der Rampe und der Leiterplatte das Halbleiterbauelement vorgesehen ist.

Weitere vorteilhafte Merkmale zu den Varianten sind den Unteransprüchen zu entnehmen.

So ist vorgesehen, dass der mindestens eine Kühlkörper Mittel zur Befestigung des Kühlkörpers an dem Gehäuseteil aufweist.

Nach einem besonderen Merkmal der Erfindung ist vorgesehen, dass der/die Kühlkörper, frontseitig gesehen, seitlich versetzt an dem Boden des Gehäuses angeordnet sind. Der Vorteil besteht darin, dass hierdurch die Abfuhr der durch die Kühlkörper erzeugten Wärme optimiert wird. Dies insofern, als durch die Konvektion jeder einzelne Kühlkörper gesondert von frischer Luft umströmt wird. Durch die seitlich versetzte Anordnung der Kühlkörper an dem Boden des Gehäuses auf der Außenseite des Gehäusebodens wird darüber hinaus Platz geschaffen für die Anordnung weiterer zu kühlender Elemente oder Aggregate, beispielsweise von Drosseln, die neben den Kühlkörpern auf der Außenseite des Bodens an dem Gehäuse angebracht werden können. Je nachdem, wo derartige zu kühlende Elemente, beispielsweise Drosseln, angeordnet sind, werden diese zwar mit der vorgewärmten Luft durch den darunter befindlichen Kühlkörper beaufschlagt, die Kühlwirkung reicht dennoch in vielen Fällen aus, um einen einwandfreien Betrieb auch dieser Elemente zu gewährleisten.

Des Weiteren ist vorgesehen, dass die Leiterplatten über die Halbleiterbauelemente mit dem jeweiligen Kühlkörper in Verbindung stehen.

Wie bereits an anderer Stelle erläutert, werden die Wechselrichter bevorzugt im Außenbereich eingesetzt, d. h. die Wechselrichter sind Umgebungseinflüssen ausgesetzt, wie insbesondere auch Feuchtigkeit. Das heißt, Wechselrichtergehäuse müssen so ausgebildet sein, dass insbesondere im Bereich der Kabeldurchlässe gewährleistet ist, dass keine Feuchtigkeit eindringen kann. Insofern ist bei dem erfindungsgemäßen Gehäuse vorgesehen, dass dieses Gehäuse im eingebauten Zustand auf seiner Unterseite einen sogenannten Anschlussbereich für ein oder mehrere Stromkabel aufweist. Hierbei ist insbesondere vorgesehen, dass der Anschlussbereich eine schräg verlaufende Wand mit abdichtbarem Durchlass für die einlaufenden Kabel besitzt. In diesem Zusammenhang ist darauf hinzuweisen, dass die Kabel, die in den Anschlussbereich eingeführt werden, bei Batteriewechselrichtern für kleine Batteriespannungen sehr dick und relativ steif sind. Das heißt, dass die Batterieleitungen in der vorgegebenen Richtung in den Anschlussbereich, z. B. in Form einer Anschlusskammer, eingeführt werden sollten, um eine übermäßige Biegung der Batterieleitungen und damit entsprechende Biegebeanspruchungen auf die Dichtungen in der Wand des Anschlussgehäuses zu vermeiden. Insofern ist die Wand für die Durchführung der Batterieleitungen von der Seite des Gehäuses gesehen schräg verlaufend ausgebildet. Diese Schräge dient gleichzeitig als Düse, um Kühlluft in Richtung der an der Unterseite liegenden Kühlkörper zu leiten.

Nach einem weiteren Merkmal der Erfindung zeigt der Anschlussbereich mindestens eine Polleiste, z. B. ausgebildet als Kupferschiene, mit mehreren Anschlussklemmen zur Aufnahme der abgehenden und ankommenden Stromkabel. Hierbei ist insbesondere mindestens zwei Polleisten vorgesehen, wobei jede Polleiste mit von außen über den Anschlussbereich zugeführten Kabeln verbunden ist, wobei die übrigen Anschlussklemmen einer solchen Polleiste zur Aufnahme einzelner Kabel zur Verbindung mit den entsprechenden Anschlüssen auf der Leiterplatte dienen. Dies hat den Vorteil, dass der dicke Kabelbaum oder Kabelstrang der Batterieleitungen, der sehr steif ist und der in den Anschlussbereich eingeführt wird, im Übergang in den Anschlussbereich nur schwierig abzudichten ist, aber der Übergang des einzelnen Kabels von den jeweiligen Polleisten in das eigentliche Wechselrichtergehäuse aufgrund der höheren Elastizität dieser dünneren Kabel besser abzudichten ist. Denn es ist sicherzustellen, dass das Wechselrichtergehäuse vollständig gegen eintretende Feuchtigkeit geschützt ist, wobei der Anschlussbereich demgegenüber nur grob zu schützen ist, da dort keine elektrischen Bauteile vorgefunden werden, die feuchtigkeitsempfindlich sind. Weiter kann durch die Aufspaltung in mehrere Leitungen die Zuführung eines großen Batteriestromes auf die Leiterplatte ermöglicht werden, ohne dass diese an der Kontaktstelle zu heiß wird.

Anhand der Zeichnungen wird die Erfindung mit den beiden Varianten nachstehend beispielhaft näher erläutert.
- Fig. 1: zeigt das Wechselrichtergehäuse einer ersten Variante in einer Seitenansicht;
- Fig. 2: zeigt eine Ansicht gemäß der Linie II-II aus Fig. 1 auf das Wechselrichtergehäuse;
- Fig. 3: zeigt das Wechselrichtergehäuse in einer zweiten Variante in einer Seitenansicht.

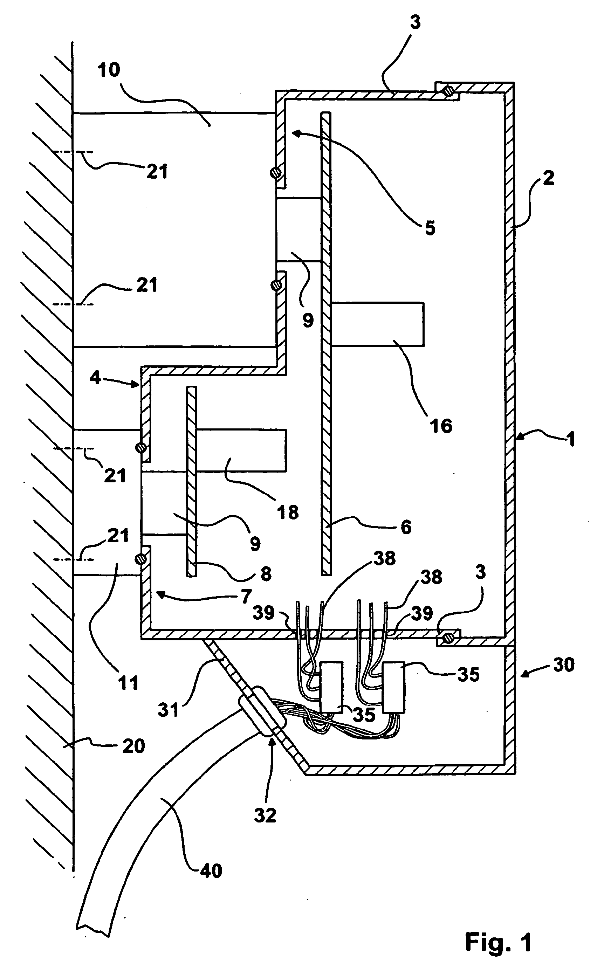

Das insgesamt mit 1 bezeichnete Wechselrichtergehäuse umfasst nach der ersten Variante einen Deckel 2, eine Wand 3 sowie den insgesamt mit 4 bezeichneten stufenförmig verlaufenden Boden. Im Bereich der in Fig. 1 oberen Stufe 5 befindet sich die mit 6 bezeichnete Leiterplatte, wohingegen im Bereich der Stufe 7 die mit 8 bezeichnete Leiterplatte angeordnet ist. Die Leiterplatten 6 und 8 sind jeweils durch die Halbleiterbauelemente 9 mit einem Kühlkörper 10 und 11 verbunden, wobei die Kühlkörper 10 und 11 eine unterschiedliche Höhe aufweisen. Die Leiterplatten 6 und 8 zeigen darüber hinaus weitere Bauteile, beispielsweise magnetische Bauteile oder Kondensatoren 16 und 18. Die Leiterplatte 6 weist gegenüber der Leiterplatte 8 eine größere Erstreckung auf. Im eingebauten Zustand weisen die Kühlkörper auf ihrer Unterseite, also der der Wand 20 zugewandten Seite, eine Ebene auf, so dass das Gehäuse insgesamt plan an der Wand angebracht werden kann. Die Anbringung an der Wand 20 erfolgt durch angedeutete Schrauben 21.

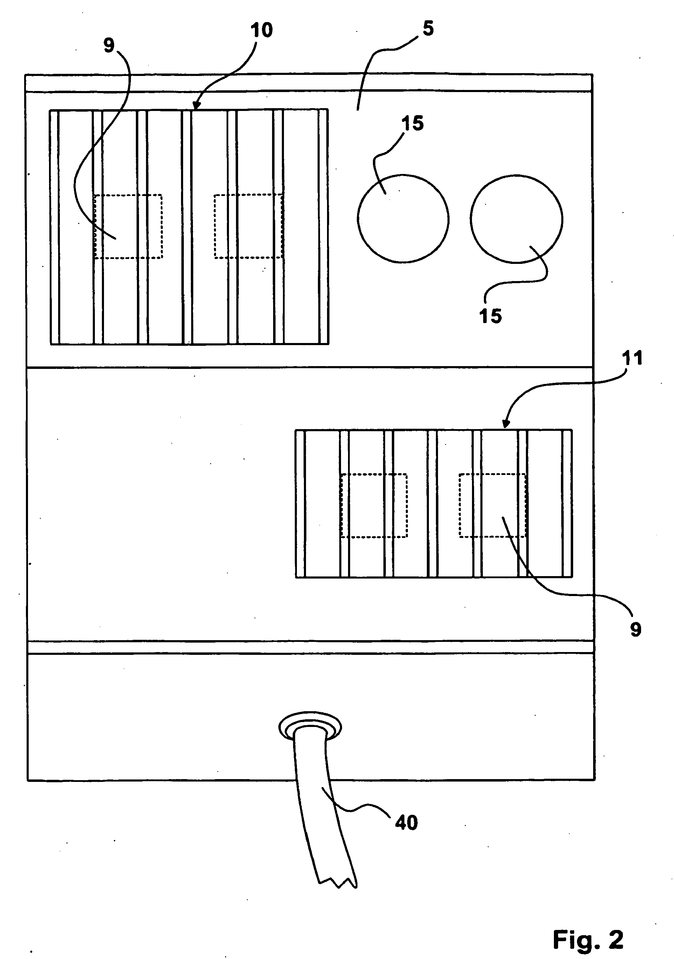

Wie sich insbesondere aus der Fig. 2 ergibt, sind die Kühlkörper 10 und 11 in der Draufsicht versetzt nebeneinander auf der Außenseite des Bodens 4 angeordnet. Das bedeutet, dass ein jeder Kühlkörper 10, 11 im Wege der Konvektion gesondert von Luft durchströmt wird. Durch die außen angeordneten Kühlkörper wird somit eine natürliche Konvektion und damit eine optimale Kühlung bei ansonsten dichtem Gehäuse ermöglicht. Des Weiteren wird durch die Anordnung der Kühlkörper auf der Außenseite des Bodens 4 erreicht, dass die Kühlkörper als heiße Teile von außen nicht zugänglich sind und so auch keine Verletzungsgefahr für Bedienpersonal besteht.

Wie bereits an anderer Stelle erläutert, sind die Kühlkörper seitlich versetzt zueinander an dem Boden 4 des Gehäuses angeordnet. Hierdurch besteht Raum für die Anbringung weiterer zu kühlender Aggregate, z. B. von Drosseln 15, die im Bereich der Stufe 5 angeordnet sein können. Diese werden zwar mit der durch den Kühlkörper 11 bereits erwärmten Luft gekühlt, jedoch reicht diese Kühlwirkung immer noch aus, um den Betrieb dieser Drosseln auch bei warmer Umgebung zu gewährleisten.

Gegenstand der Erfindung ist ebenfalls die Anordnung eines Anschlussbereiches 30 in Form einer Anschlusskammer an dem mit 1 bezeichneten Gehäuse. Dieser Anschlussbereich oder Anschlusskammer umfasst eine schräge Wand 31, die auf die Gebäudewand 20 zugerichtet ist, wobei die schräge Wand 31 eine Öffnung 32 zum Durchlass des mit 40 bezeichneten Bündels von Batterieleitungen aufweist. Durch die Anordnung der Wand 31 in Richtung auf die Gebäudewand 20 ist der Durchgang des Batteriekabels 40 vor direkten Witterungseinflüssen geschützt. Im Bereich der Anschlusskammer 30 befinden sich zwei Polleisten 35, wobei die Kabel des Kabelbaums 40 mit diesen Polleisten 35 über entsprechende Anschlussklemmen verbunden sind, wobei jede Polleiste weitere Anschlussklemmen aufweist, wobei die abgehenden relativ gesehen dünneren Kabel 38 einzeln durch die Wand 3 des Gehäuses 1 des Wechselrichters bis in das Gehäuseinnere geführt werden. Diese einzelnen Kabel 38 sind im Bereich des Durchgangs durch die Wand 3 durch eine Gummimanschette 39 abgedichtet. Es sei an dieser Stelle darauf hingewiesen, dass die Abdichtung einzelner dünner Kabel wesentlich einfacher zu bewerkstelligen ist als die Abdichtung eines dicken Kabels oder Kabelbaumes, da die dünnen Kabel wesentlich elastischer sind als ein dickes Kabel oder gar ein Kabelbaum in seiner Gesamtheit. Die Anschlusskammer oder der -bereich 30 selbst ist zwar ebenfalls gegen eindringende Feuchtigkeit abgedichtet, jedoch kann keine Dichtigkeit gewährleistet werden wie beim Übergang von der Anschlusskammer 30 in das Gehäuse 1.

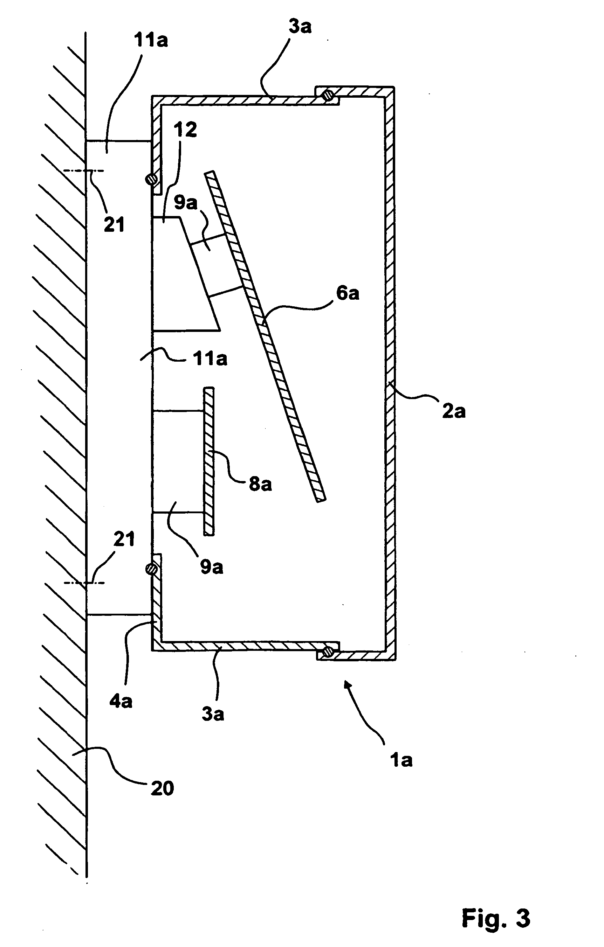

Die Darstellung gemäß Fig. 3 zeigt die zweite Variante, wobei dort lediglich das eigentliche Gehäuse dargestellt ist, nicht aber die Anschlusskammer 30, die allerdings dort ebenfalls vorgesehen sein kann.

Das mit 1a bezeichnete Gehäuse besitzt einen Deckel 2a, Wände 3a und einen Boden 4a. Der Boden weist eine Öffnung zur Aufnahme des Kühlkörpers 11a auf. Auf dem Kühlkörper 11a sitzt ein Halbleiterbauelement mit der Leiterplatte 8a. Diese Leiterplatte verläuft parallel zum Boden oder auch der Oberseite des Kühlkörpers 11a.

Der Kühlkörper zeigt des Weiteren eine klotzförmige Rampe 12 mit einer schrägen Oberseite, auf der ein Halbleiterbauelement 9a lagert. Dieses Halbleiterbauelement verläuft schräg, so dass auch die Leiterplatte schräg steht und hierbei die Leiterplatte 8a beabstandet überlappt oder überragt. Ein Abstand zwischen den Leiterplatten im Bereich der Überlappung ist wegen der erforderlichen Kühlung im Gehäuse sinnvoll.

## Patentansprüche

1. Wechselrichter, wobei der Boden des Gehäuses (1) des Wechselrichters stufenförmig ausgebildet ist, wobei Kühlkörper (10, 11) an dem stufenförmigen Boden außen angeordnet sind, wobei mindestens zwei Leiterplatten (6, 8) vorgesehen sind, die einander überlappend durch Halbleiterbauelemente mit dem jeweiligen Kühlkörper (10, 11) in Verbindung stehen.

2. Wechselrichter nach Anspruch 1,
**dadurch gekennzeichnet,**
**dass** die Höhe der Kühlkörper (10, 11) zur Anbringung an dem stufenförmigen Boden derart gewählt ist, dass die Kühlkörper (10, 11) im am Gehäuse (1) angebauten Zustand eine Ebene bilden.

3. Wechselrichter mit mindestens einem außerhalb des Gehäuses (1 a) angeordneten Kühlkörper (11a) und mindestens zwei Leiterplatten (6a, 8a), die mit dem mindestens einen Kühlkörper (11a) durch Halbleiterbauelemente in Verbindung stehen, wobei die eine Leiterplatte (6a) die andere Leiterplatte (8c) im Gehäuse (1 a) schrägstehend überlappt.

4. Wechselrichter nach Anspruch 3,
**dadurch gekennzeichnet,**
**dass** die schräg stehende Leiterplatte (6a) durch eine Rampe (12) mit dem mindestens einem Kühlkörper (11a) in Verbindung steht.

5. Wechselrichter nach Anspruch 4,
**dadurch gekennzeichnet,**
**dass** zwischen Rampe (12) und Leiterplatte (6a) das Halbleiterelement (9a) angeordnet ist.

6. Wechselrichter nach einem der voranstehenden Ansprüche,
**dadurch gekennzeichnet,**
**dass** die Kühlkörper (10, 11) bei Ansicht von vorn seitlich versetzt im Gehäuses (1) angeordnet sind.

7. Wechselrichter nach einem der voranstehenden Ansprüche,
**dadurch gekennzeichnet,**
**dass** die Leiterplatten (6, 8, 6a, 8a) durch Halbleiterbauelemente (9, 9a) mit dem jeweiligen Kühlkörper (10, 11, 11a) in Verbindung stehen.

8. Wechselrichter nach einem der voranstehenden Ansprüche,
**dadurch gekennzeichnet,**
**dass** die Magnetbauteile (15) durch den Luftstrom durch die Kühlkörper (10,11,11 a) mitgekühlt werden.

9. Wechselrichter nach einem der voranstehenden Ansprüche,
**dadurch gekennzeichnet,**
**dass** die Kühlkörper (10, 11, 11a) Mittel (21) zur Befestigung an einem Gebäudeteil (20) aufweisen.

10. Wechselrichter nach Anspruch 9,
**dadurch gekennzeichnet,**
**dass** das Gehäuse (1, 1a) einen Anschlussbereich (30) für die Kabelzuführung aufweist.

11. Wechselrichter nach einem der voranstehenden Ansprüche,
**dadurch gekennzeichnet,**
**dass** der Anschlussbereich (30) mindestens eine Polleiste (35) mit mehreren Anschlussklemmen aufweist.

12. Wechselrichter nach einem der voranstehenden Ansprüche,
**dadurch gekennzeichnet,**
**dass** der Übergang von der Anschlusskammer (30) zum Gehäuse (1, 1 a) im Bereich der Kabeldurchlässe durch Gummimanschetten (39) abgedichtet ist.

13. Wechselrichter nach einem der voranstehenden Ansprüche,
**dadurch gekennzeichnet,**
**dass** der Anschlussbereich eine schräg verlaufende Wand (31) mit abdichtbarer Öffnung (32) für die Kabel (40) aufweist.

14. Wechselrichter nach einem der voranstehenden Ansprüche,
**dadurch gekennzeichnet,**
**dass** das Gehäuse (1, 1 a, 1 b) als Gussgehäuse ausgebildet ist, wobei das Gussgehäuse (1, 1 a, 1 b) Kühlrippen aufweist.

## Claims

1. A power inverter, with the bottom of the housing (1) of the power inverter being configured to be stepped, cooling bodies (10, 11) being disposed on the exterior face of the stepped bottom, at least two printed circuit boards (6, 8) that overlap each other and communicate with the respective one of the cooling bodies (10, 11) through semiconductor components being provided.

2. The power inverter as set forth in claim 1,
**characterized in**
**that** the height of the cooling bodies (10, 11) for mounting to the stepped bottom is selected so that the cooling bodies (10, 11) form a plane when mounted to the housing (1).

3. A power inverter with at least one cooling body (11 a) disposed outside of the housing (1a) and at least two printed circuit boards (6a, 8a) that communicate with the at least one cooling body (11 a) through semiconductor elements, the one printed circuit board (6a) overlapping the other printed circuit board (8c) in the housing (1 a) at an incline.

4. The power inverter as set forth in claim 3,
**characterized in**
**that** the inclined printed circuit board (6a) communicates with the at least one cooling body (11 a) through a ramp (12).

5. The power inverter as set forth in claim 4,
**characterized in**
**that** the semiconductor component (9a) is interposed between the ramp (12) and the printed circuit board (6a).

6. The power inverter as set forth in any one of the above mentioned claims,
**characterized in**
**that** the cooling bodies (10, 11) are arranged laterally offset in the housing (1) when viewed from the front.

7. The power inverter as set forth in any one of the above mentioned claims,
**characterized in**
**that** the printed circuit boards (6, 8, 6a, 8a) communicate with a respective one of the cooling bodies (10, 11, 11a) through semiconductor components (9, 9a).

8. The power inverter as set forth in any one of the above mentioned claims,
**characterized in**
**that** the magnetic components (15) are also cooled by the air flowing through the cooling bodies (10, 11, 11 a).

9. The power inverter as set forth in any one of the above mentioned claims,
**characterized in**
**that** the cooling bodies (10, 11, 11a) comprise means (21) for fastening to a housing part (20).

10. The power inverter as set forth in claim 9,
**characterized in**
**that** the housing (1, 1 a) comprises a connection region (30) for the cable supply.

11. The power inverter as set forth in any one of the above mentioned claims,
**characterized in**
**that** the connection region (30) comprises at least one pole block (35) with a plurality of terminals.

12. The power inverter as set forth in any one of the above mentioned claims,
**characterized in**
**that** the transition from the connection chamber (30) to the housing (1, 1 a) is sealed with rubber collars (39) in the region of the cable passageways.

13. The power inverter as set forth in any one of the above mentioned claims,
**characterized in**
**that** the connection region comprises a wall (31) oriented at an incline and having a sealable opening (32) for the cables (40).

14. The power inverter as set forth in any one of the above mentioned claims,
**characterized in**
**that** the housing (1, 1 a, 1b) is configured to be a cast housing, said cast housing (1, 1 a, 1 b) comprising cooling ribs.

## Revendications

1. Onduleur, où le fond du boîtier (1) de l'onduleur est réalisé en gradins, des dissipateurs thermiques (10, 11) étant disposés sur le fond en gradins, sur la face extérieure de celui-ci, au moins deux circuits imprimés (6, 8) se chevauchant et étant reliés avec le dissipateur thermique (10, 11) respectif par l'intermédiaire de composants semi-conducteurs étant prévus.

2. Onduleur selon la revendication 1,
**caractérisé en ce**
**que** la hauteur des dissipateurs thermiques (10, 11) destinés à être montés sur le fond en gradins est choisie de telle sorte que les dissipateurs thermiques (10, 11), quand ils sont montés sur le boîtier (1), forment une surface plane.

3. Onduleur avec au moins un dissipateur thermique (11a) disposé en à l'extérieur du boîtier (1 a) et avec au moins deux circuits imprimés (6a, 8a) qui sont reliés avec l'au moins un dissipateur thermique (11a) par l'intermédiaire de composants semi-conducteurs, l'un des circuits imprimés (6a) chevauchant obliquement l'autre circuit imprimé (8c) dans le boîtier (1 a).

4. Onduleur selon la revendication 3,
**caractérisé en ce**
**que** le circuit imprimé (6a) oblique est relié avec l'au moins un dissipateur thermique (11 a) par l'intermédiaire d'une rampe (12).

5. Onduleur selon la revendication 4,
**caractérisé en ce**
**que** l'élément semi-conducteur (9a) est interposé entre la rampe (12) et le circuit imprimé (6a).

6. Onduleur selon l'une quelconque des revendications précédentes,
**caractérisé en ce**
**que** les dissipateurs thermiques (10, 11) sont décalés latéralement dans le boîtier (1) en vue de devant.

7. Onduleur selon l'une quelconque des revendications précédentes,
**caractérisé en ce**
**que** les circuits imprimés (6, 8, 6a, 8a) sont reliés avec le dissipateur thermique respectif (10, 11, 11 a) par l'intermédiaire de composants semi-conducteurs (9, 9a).

8. Onduleur selon l'une quelconque des revendications précédentes,
**caractérisé en ce**
**que** les composants magnétiques (15) sont également refroidis par le flux d'air passant par les dissipateurs thermiques (10, 11, 11 a).

9. Onduleur selon l'une quelconque des revendications précédentes,
**caractérisé en ce**
**que** les dissipateurs thermiques (10, 11, 11 a) comportent des moyens (21) destinés à être fixés sur une partie du boîtier (20).

10. Onduleur selon la revendication 9,
**caractérisé en ce**
**que** le boîtier (1, 1 a) comporte une zone de raccordement (30) pour l'accès de câblage.

11. Onduleur selon la revendication 4,
**caractérisé en ce**
**que** la zone de raccordement (30) comporte au moins une barrette de bornes (35) avec plusieurs bornes de raccordement.

12. Onduleur selon l'une quelconque des revendications précédentes,
**caractérisé en ce**
**que** l'étanchéité de la transition entre la chambre de raccordement (30) et le boîtier (1, 1 a) à la hauteur des passages de câbles est assurée par des manchons en caoutchouc (39).

13. Onduleur selon l'une quelconque des revendications précédentes,
**caractérisé en ce**
**que** la zone de raccordement comporte une paroi oblique (31) avec une ouverture (32) pour les câbles (40) qui est apte à être rendue étanche.

14. Onduleur selon l'une quelconque des revendications précédentes,
**caractérisé en ce**
**que** le boîtier (1, 1 a, 1 b) est réalisé sous forme de boîtier en fonte, ce boîtier en fonte (1, 1 a, 1 b) comportant des nervures de refroidissement.
